# EUROPÄISCHE PATENTSCHRIFT

(11) **EP 3 637 059 B1**
(45) Veröffentlichungstag und Bekanntmachung des Hinweises auf die Patenterteilung: **10.01.2024**
(21) Anmeldenummer: 19195289.4
(22) Anmeldetag: 04.09.2019
(51) Int. Cl.: G01D 3/08, H03M 1/10, G01D 21/00, H03M 1/12

(54) **SICHERHEITSSCHALTUNG UND VERFAHREN ZUM TESTEN EINER SICHERHEITSSCHALTUNG IN EINER AUTOMATISIERUNGSANLAGE**
SAFETY CIRCUIT AND METHOD OF TESTING A SAFETY CIRCUIT IN AN AUTOMATION SYSTEM
CIRCUIT DE SÉCURITÉ ET PROCÉDÉ D'ESSAI D'UN CIRCUIT DE SÉCURITÉ DANS UNE INSTALLATION D'AUTOMATISATION

(30) Priorität: 12.10.2018 DE 102018008109
(43) Veröffentlichungstag der Anmeldung: 15.04.2020
(73) Patentinhaber: Wago Verwaltungsgesellschaft mbH, 32423 Minden (DE)
(72) Erfinder: Bülow, Alexander, 31655 Stadthagen (DE); Voß, Christian, 32427 Minden (DE); Meyer, Torsten, 31621 Penningsehl (DE)
(74) Vertreter: Müller, Wolf-Christian

(56) Entgegenhaltungen:
- DE-A1- 19 640 937
- DE-A1-102005 030 276
- DE-A1-102013 111 888
- JP-A- 2003 114 266
- JP-B2- 5 927 865

## Beschreibung

### GEBIET

Die vorliegende Erfindung bezieht sich auf eine Vorrichtung und ein Verfahren zum Testen einer Sicherheitsschaltung, insbesondere für analoge Eingangssignale in einem Automatisierungssystem.

### HINTERGRUND

In der Automatisierungstechnik sind Systeme bekannt, in denen Sensoren physikalische Größen z.B. einer Umgebung aufnehmen und in elektrische Signale umwandeln. Die elektrischen Signale können zur Auswertung an eine Steuerung (SPS) übermittelt werden. Ein Prozessor in der Steuerung verarbeitet die Signale mit Hilfe eines Steuerprogramms, z.B. zur Steuerung von Aktoren, die einen Prozess-Schritt ausführen. Der Prozess-Schritt kann dabei ein Teilprozess als Bestandteil eines Gesamtprozesses sein. Hierbei ist es notwendig, die korrekte Übermittlung der elektrischen Signale von Zeit zu Zeit oder zyklisch zu prüfen, um die ordnungsgemäße Funktionsweise sicherzustellen. Vorteilhafterweise erfolgt eine Prüfung ohne eine Unterbrechung des Prozesses. Die elektrischen Signale können dabei in digitaler oder analoger Form vorliegen. Liegen Signale von Sensoren in analoger Form vor, können die Signale zur weiteren Verarbeitung in sogenannten Analog- Digital- Umsetzvorrichtungen (AD-Umsetzvorrichtungen) zur weiteren Verarbeitung, beispielsweise durch eine Steuer- und Auswerteeinheit digitalisiert, in digitaler Form aufbereitet und weitergeleitet werden. Dabei kann die AD-Umsetzvorrichtung einen oder mehrere AD-Umsetzer aufweisen.

Aus der DE 10 2013 111 888 A1 ist eine Sicherheitsvorrichtung zum mehrkanaligen Verarbeiten eines analogen Eingangssignals bekannt, bei der eine Testeinrichtung jeweils an einen weiteren zusätzlichen Eingang einer ersten und einer zweiten Schalteinrichtung angeschlossen ist. Die Testeinrichtung ist dazu ausgebildet, definierte Testsignale zu erzeugen. Beispielsweise kann die Testeinrichtung mittels eines Steuersignals von einem Mikrocontroller Testsignale erzeugen und über die Schalteinrichtung dem AD-Umsetzer zuführen, mit dem der gesamte Wertebereich der AD-Umsetzer getestet werden kann. Hierzu werden die von den AD-Umsetzern unter Ansprechen auf das Testsignal erzeugten Ausgangssignale, dem oder den Mikrocontrollern zugeführt und auf Richtigkeit geprüft.

In der DE 10 2011 050 539 A1 wird eine Messvorrichtung mit wenigsten zwei Messkanälen vorgeschlagen, wobei jeder Messkanal einen AD-Umsetzer zur Umsetzung einer analogen Spannung in einen digitalen Spannungswert und eine Logikeinheit aufweist. Ein Messkanal ist als sicherer Messkanal ausgeführt und umfasst einen Multiplexer, wobei mit dem Multiplexer die analoge Spannung zwischen einer Messspannung und einer Referenzspannung umgeschaltet werden kann. Die Logikeinheit wenigstens eines anderen Messkanals ist als Referenzerzeuger ausgeführt, um die Referenzspannung bereitzustellen und den Multiplexer zwischen der Messspannung und der Referenzspannung umzuschalten.

Weiterhin ist aus der DE 10 2005 011 406 A1 ein Zwei-Kanal-Verfahren zum Ermitteln zumindest eines Ausgangssignals bekannt. Dabei werden zwei voneinander unabhängige Kanäle bereitgestellt. Die Eingangssignale werden abwechselnd diesen Kanälen zugeführt, wobei ein Multiplexer zum Umschalten zwischen den Kanälen dient. Ein Mikroprozessor in einem der Kanäle stellt Testeingangssignale bereit, welche dem Kanal zugeführt werden, an dem die sich ändernden Eingangssignale gegenwärtig nicht anliegen. Entsprechend gibt dieser Kanal Ausgangssignale aus, die mit einem Erwartungswert verglichen werden, um zu prüfen, ob dieser Kanal korrekt arbeitet. Gleichzeitig dient der andere Kanal zur Herstellung des Ausgangssignals. Anschließend wird von dem Multiplexer aufgrund eines Steuersignals umgeschaltet. Dabei ist in jedem Kanal ein AD-Umsetzer angeordnet, welcher die analoge Messspannung in einen digitalen Spannungswert umwandelt.

Aus der DE 10 2005 030 276 A1 ist eine Sicherheitsschaltvorrichtung zum sicheren Abschalten eines Verbrauchers in einer automatisiert arbeitenden Anlage bekannt, mit zumindest einem Eingang zum Aufnehmen eines analogen Eingangssignals, mit einem A/D-Wandler, der das analoge Eingangssignal in ein digitales Signal wandelt, mit einer Auswerte- und Steuereinheit, der das digitale Signal zugeführt ist, und mit zumindest einem Ausgangsschaltelement, das von der Auswerte- und Steuereinheit in Abhängigkeit von dem digitalen Signal angesteuert wird. Die Sicherheitsschaltvorrichtung weist hierbei einen analogen Signalkombinierer auf, der dazu ausgebildet ist, dem analogen Eingangssignal ein analoges Testsignal zu überlagern, um ein analoges Kombinationssignal zu bilden, wobei dem A/D-Wandler das analoge Kombinationssignal zugeführt wird.

Die JP 5 927 865 B2 betrifft eine Steuerfunktion mit einer Sensorausfall-Diagnosefunktion zur Erkennung eines Ausfalls eines Sensorelementes. In einer bevorzugten Ausführungsform wird gleichzeitig mit dem Aus- und Einschalten eines Zündschalters eine ECU-Fehlerdiagnose durch einen Timer gestartet und von einem Testsignalgenerator ein Testsignal erzeugt, welches das Sensorsignal überlagert.

Der Erfindung liegt die Aufgabe zu Grunde eine möglichst verbesserte Sicherheitsschaltung bereitzustellen. Diese Aufgabe wird durch die Merkmale des Anspruchs 1 gelöst. Vorteilhafte Weiterbildungen und Ausgestaltungen sind Gegenstand der abhängigen Ansprüche und in der Beschreibung enthalten.

Demzufolge ist eine Sicherheitsschaltung vorgesehen zum mehrkanaligen Verarbeiten eines Eingangssignals, insbesondere eines Sensorsignals mit einer Eingangsschaltung, eingerichtet zur Eingabe des Eingangssignals und Bereitstellung des Eingangssignals an seinem Ausgang.

Die Sicherheitsschaltung umfasst weiterhin eine AD-Umsetzvorrichtung mit einem ersten Analog-Eingang und einem zweiten Analog-Eingang sowie mindestens einem Digital-Ausgang.

Ferner weist die Sicherheitsschaltung eine erste Signalleitung auf, die an dem Ausgang der Eingangsschaltung und an dem ersten Analog-Eingang der AD-Umsetzvorrichtung zur Weiterleitung eines ersten Eingangssignals in analoger Form angeschlossen ist, wobei die AD-Umsetzvorrichtung eingerichtet ist, das erste Eingangssignal in analoger Form am ersten Analog-Eingang in ein erstes Eingangssignal in digitaler Form umzusetzen und an dem mindestens einen Digital-Ausgang auszugeben.

Die Sicherheitsschaltung weist weiterhin eine zweite Signalleitung auf, die an dem Ausgang der Eingangsschaltung und an dem zweiten Analog-Eingang der AD-Umsetzvorrichtung zur Weiterleitung eines zweiten Eingangssignals in analoger Form angeschlossen ist, wobei die AD-Umsetzvorrichtung eingerichtet ist, das zweite Eingangssignal in analoger Form am zweiten Analog-Eingang in ein zweites Eingangssignal in digitaler Form umzusetzen und an dem Digital-Ausgang auszugeben.

Die Sicherheitsschaltung weist weiterhin eine Steuer- und Auswertevorrichtung zur Auswertung des ersten Eingangssignals in digitaler Form und des zweiten Eingangssignals in digitaler Form auf, wobei der mindestens eine Digital-Ausgang der AD-Umsetzvorrichtung mit mindestens einem Eingang der Steuer- und Auswertevorrichtung verbunden ist.

Die Sicherheitsschaltung weist darüber hinaus eine Testeinrichtung zur Ausgabe eines analogen Testsignals auf, wobei die Testeinrichtung einen Steuereingang aufweist, der mit einem Steuerausgang der Steuer- und Auswertevorrichtung verbunden ist. Die Steuer- und Auswertevorrichtung ist ferner eingerichtet, die Testeinrichtung zu steuern. Dabei ist besonders vorteilhaft, dass die Testeinrichtung einen ersten Analog-Test-Ausgang zur Ausgabe des analogen Testsignals aufweist, der in einem ersten Knotenpunkt an die erste Signalleitung angeschlossen ist und dass die Testeinrichtung einen zweiten Analog-Test-Ausgang zur Ausgabe des analogen Testsignals aufweist, der in einem zweiten Knotenpunkt an die zweite Signalleitung angeschlossen ist.

In diesem Zusammenhang ist unter der Sicherheitsschaltung, wie sie in der Beschreibung und in den Ansprüchen verwendet wird, insbesondere eine elektrische Vorrichtung zu verstehen, die Signale von Sensoren zur weiteren Verarbeitung in der Steuer- und Auswerteeinrichtung umwandelt. Die Sicherheitsschaltung weist zudem die Testeinrichtung auf, wobei in einer vorteilhaften Ausgestaltung der Erfindung während eines Testzeitraumes die Signalleitungen auf Leitungsbruch und/oder Kurzschlüssen und/oder auf die korrekte Arbeitsweise der AD-Umsetzvorrichtung geprüft werden können.

Gemäß einer vorteilhaften Ausgestaltung kann die Sicherheitssteuerung während des Testzeitraumes weiterhin Sensorsignale aufnehmen und aufgrund derer einen Prozess steuern und im Fehlerfall diesen Prozess gegebenenfalls unterbrechen und/oder ein Fehlersignal auslösen.

Bei den von Sensoren zur Verfügung gestellten Signalen kann zwischen digitalen und analogen Eingangssignalen unterschieden werden. Während digitale Signale direkt, beispielsweise in einer Steuer- und Auswerteeinheit ausgewertet oder verarbeitet werden können, kann eine Aufbereitung oder Anpassung analoger Signale vorteilhaft sein. Zur Aufbereitung oder Anpassung der analogen Signale umfasst die Sicherheitsschaltung eine Eingangsschaltung.

Bei einem analogen Signal, wie es von einem entsprechenden Sensor ausgegeben wird, kann es sich beispielsweise um eine Spannung handeln, die beispielsweise eine Temperatur oder eine andere physikalische Größe oder Eigenschaft der Umgebung repräsentiert.

Das Wirkprinzip dieser Art von Sensoren beruht beispielsweise darauf, dass sich in Abhängigkeit von der Messgröße (Temperatur, Länge ...) der ohmsche Widerstand des Sensors ändert. Diese Widerstandsänderung führt zu einem veränderten Spannungsabfall am Sensor, der dann mit einem einfachen Spannungsteiler oder einer Brückenschaltung als analoges Signal erfasst werden kann.

Zur weiteren Verarbeitung des analogen Signals sind sogenannte AD-Umsetzer vorteilhaft. Der AD- Umsetzer diskretisiert ein zeit-kontinuierliches Eingangssignal (entweder durch sein Funktionsprinzip oder durch eine vorgeschaltete bzw. integrierte Sample-and-Hold-Stufe) in einzelne diskrete Abtastwerte. Diese Abtastwerte werden anschließend in Digitalwerte umgesetzt. Auf Grund einer endlichen Anzahl von möglichen Ausgangswerten erfolgt dabei immer eine Quantisierung.

Das Ergebnis einer AD-Umsetzung stellt sich beispielsweise in einem Signal-Zeit-Diagramm als eine Punktfolge mit gestuften horizontalen und vertikalen Abständen dar. Die Hauptparameter eines AD-Umsetzers sind seine Bittiefe, seine maximale Abtastrate und seine Fähigkeit zum Oversampling. Die Bittiefe und das Oversampling eines AD-Umsetzers begrenzen die maximal mögliche Genauigkeit mit der das Eingangssignal umgesetzt werden kann. AD-Umsetzer sind heute in Mikrochips integriert und können ein-kanalig oder auch mehr-kanalig ausgeführt sein. Mehr-kanalig bedeutet in diesem Zusammenhang, dass beispielsweise mehrere Signale nahezu gleichzeitig und unabhängig voneinander weitergeleitet bzw. verarbeitet werden können. Die AD-Umsetzvorrichtungen können integrierte Multiplexer umfassen, wobei die integrierten Multiplexer eingerichtet sind mehrere Kanäle auf einen AD-Umsetzer zu schalten, so dass beispielsweise zyklisch alle Kanäle nacheinander auf den AD-Umsetzer geschaltet werden können.

Die Testeinrichtung weist beispielsweise ebenfalls einen Multiplexer mit einer ansteuerbaren Logik und einer Schaltvorrichtung, bestehend aus mehreren Schaltern auf, die beispielsweise unabhängig voneinander schaltbar sind und vorzugsweise mit einer externen Signalquelle verbunden werden können.

Die Steuer- und Auswertevorrichtung besteht vorteilhafterweise aus einer Recheneinheit und einem Speicher mit ausführbaren Programmen, wobei die Recheneinheit aus einem Prozessor, einem Mikrocontroller oder vorzugsweise aus zwei Mikrocontrollern bestehen kann.

Die Programme bearbeiten die Steuer- und Auswerteaufgaben, wobei die Programme auf einem Prozessor, einem Mikrocontroller oder zwei Mikrocontrollern gleichzeitig oder auch getrennt nach Steuer- und/oder Auswerteprogrammen ausgeführt werden können.

Gemäß einer vorteilhaften Weiterbildung weist die Testeinrichtung der Sicherheitsschaltung einen Test-Eingang zur Eingabe des analogen Testsignals auf, wobei zumindest während eines Testzeitraumes das analoge Testsignal anliegt. Insbesondere ist eine Signalquelle mit dem Test-Eingang verbunden. Die Signalquelle ist dazu ausgebildet das analoge Testsignal, insbesondere mittels einer Spannungs- oder Stromquelle zu erzeugen.

Der Test-Eingang ist dazu geeignet ein vorteilhafterweise kontinuierliches analoges Signal, als analoges Testsignal, aufzunehmen und gegebenenfalls weiterzuleiten. Vorzugsweise handelt es sich bei der, das analoge Testsignal erzeugenden Signalquelle, um eine steuerbare Spannungs- oder Stromquelle, die dazu eingerichtet ist, die von der Steuer- und Auswertevorrichtung vorgegebenen Spannungs- oder Stromwerte als analoge Testsignale auszugeben.

Gemäß einer weiteren vorteilhaften Weiterbildung ist das analoge Testsignal ein Massepotential oder ein konstantes Spannungspotential oder ein variables Spannungspotential.

In einem einfachen Fall kann beispielsweise ein Transistor als Signalquelle verwendet werden, der den Testeingang gegen das Massepotential schaltet. Weiterhin können sowohl konstante Spannungsquellen als auch variable Spannungsquellen zur Ausgabe des analogen Testsignals Verwendung finden.

Gemäß einer vorteilhaften Weiterbildung ist das analoge Testsignal ein konstanter oder variabler Strom.

Gemäß einer weiteren vorteilhaften Weiterbildung folgt das analoge Testsignal während des Testzeitraumes einem vorgegebenen oder vorgebbaren Signalverlauf.

In diesem Zusammenhang ist das analoge Testsignal S_{TA} während des Testzeitraumes (Tₜₑₛₜ) konstant, d.h. zeitlich unverändert (S_{TA}=konst.) oder folgt einem Signalverlauf als Funktion F der Zeit (S_{TA} = F(t)).

Gemäß einer vorteilhaften Weiterbildung weist die Testeinrichtung eine Schaltvorrichtung auf, wobei die Schaltvorrichtung eingerichtet ist, das analoge Testsignal auf den ersten Analog-Test-Ausgang und/oder auf den zweiten Analog -Test-Ausgang zu schalten.

Dabei kann die Schalteinrichtung mechanische und/oder elektronische Schalter, insbesondere Halbleiterschalter aufweisen, die vorzugsweise über eine Steuerlogik ansteuerbar sind und im geschlossenen Zustand eine elektrische Verbindung derart herstellen, so dass das Testsignal an den Analog-Test-Ausgängen anliegt.

Gemäß einer vorteilhaften Weiterbildung weist die Schaltvorrichtung mindestens zwei Schalter auf, wobei die Schalter einzeln und/oder in Gruppen ansteuerbar sind.

Die Ansteuerung der Schalter wird durch die Steuerlogik vorgenommen, wobei die Steuerlogik vorzugsweise digitale Signale über einen Steuereingang, beispielsweise von der Steuer- und Auswertevorrichtung empfängt und auswertet, so dass jeder Schalter individuell geschaltet werden kann.

Es ist vorgesehen, dass die erste Signalleitung der Sicherheitsschaltung ein erstes Dämpfungselement aufweist, so dass die Eingangsschaltung, unter Zwischenschaltung des ersten Dämpfungselementes, an dem ersten Analog-Eingang der AD-Umsetzvorrichtung angeschlossen ist. Weiterhin ist vorgesehen, dass die zweite Signalleitung ein zweites Dämpfungselement aufweist, so dass die Eingangsschaltung, unter Zwischenschaltung des zweiten Dämpfungselementes, an dem zweiten Analog-Eingang der AD-Umsetzvorrichtung angeschlossen ist.

Dabei wird unter dem Begriff Dämpfungselement ein elektrisches Bauteil, wie beispielsweise ein ohmscher Widerstand oder eine Impedanz verstanden. Das Dämpfungselement wird in den Signalweg zwischen Eingangsschaltung und dem ersten bzw. zweiten Analog- Eingang der AD-Umsetzvorrichtung eingesetzt, um das Signal nach dem Dämpfungselement in Richtung der AD-Umsetzvorrichtung, zumindest im Testbetrieb, zu verändern. Dabei kann das Signal in seiner Amplitude und/oder Pegel und/oder Frequenz geändert werden.

Darüber hinaus ist vorgesehen, dass das erste Dämpfungselement, das zweite Dämpfungselement, und eine Ausgangsimpedanz der Testeinrichtung derart dimensioniert sind, dass das erste Eingangssignal in analoger Form und das analoge Testsignal während des Testzeitraumes an dem ersten Analog-Eingang der AD-Umsetzvorrichtung sich überlagern und/oder dass das zweite Eingangssignal in analoger Form und das analoge Testsignal während des Testzeitraumes an dem zweiten Analog-Eingang der AD-Umsetzvorrichtung sich überlagern derart, dass das analoge Testsignal das erste Eingangssignal in analoger Form beziehungsweise das zweite Eingangssignal in analoger Form dominiert.

Gemäß einer weiteren vorteilhaften Weiterbildung weist die Steuer- und Auswertevorrichtung einen Prozessor zur Verarbeitung des ersten Eingangssignals in digitaler Form und/oder des zweiten Eingangssignals in digitaler Form auf.

Der Prozessor in der Steuer- und Auswerteeinheit auch als Mikroprozessor bezeichnet, beinhaltet alle Bausteine, wie z.B. Rechenwerk, Steuerwerk, Register und Speichermanager in einem integrierten Chip. Dabei kann es sich bei dem Prozessor auch um ein Mehrkernprozessor handeln, der aus mehreren Prozessorkernen, insbesondere aus zwei Prozessorkernen besteht.

Gemäß einer weiteren vorteilhaften Weiterbildung weist die AD-Umsetzvorrichtung einen ersten AD-Umsetzer und einen zweiten AD-Umsetzer auf, wobei der erste AD-Umsetzer eingerichtet ist, das erste Eingangssignal in analoger Form in das erste Eingangssignal in digitaler Form umzusetzen und an dem Digital-Ausgang auszugeben und wobei der zweite AD-Umsetzer eingerichtet ist, das zweite Eingangssignal in analoger Form in das zweite Eingangssignal in digitaler Form umzusetzen und an dem Digital-Ausgang auszugeben.

Die AD-Umsetzvorrichtung ist vorzugsweise mehrkanalig aufgebaut und kann mehrere AD-Umsetzer umfassen, die gleichzeitig ein oder mehrere erste und/oder zweite Eingangssignale in analoger Form in erste und/oder zweite Eingangssignale in digitaler Form umsetzen können. Alternativ kann die AD-Umsetzvorrichtung genau einen AD-Umsetzer mit einem vorgeschalteten Multiplexer aufweisen, der mehrkanalige erste und/oder zweite Eingangssignale in analoger Form, beispielsweise auf einen AD- Umsetzer schaltet.

In einem weiteren Aspekt der Erfindung ist ein Verfahren zum Testen einer Sicherheitsschaltung vorgesehen. Die Sicherheitsschaltung weist eine Signalquelle zum Erzeugen eines analogen Testsignals und eine Testeinrichtung zur Ausgabe des analogen Testsignals auf. Im Verfahren wird das analoge Testsignal auf einer ersten Signalleitung in einem ersten Knotenpunkt und/oder auf einer zweiten Signalleitung in einem zweiten Knotenpunkt ausgegeben, so dass während eines Testzeitraumes, das an einem Analog-Eingang der Testeinrichtung anliegende analoge Testsignal über eine Schaltvorrichtung derart verbunden (verteilt) wird, dass ein erster Analog-Eingang einer ersten AD-Umsetzvorrichtung und/oder ein zweiter Analog- Eingang der AD-Umsetzvorrichtung mit dem analogen Testsignal beaufschlagt wird, so dass das analoge Testsignal mit einem ersten Eingangssignal in analoger Form an dem ersten Analog-Eingang der AD-Umsetzvorrichtung und/oder dass das analoge Testsignal mit einem zweiten Eingangssignal in analoger Form an dem zweiten Analog-Eingang der AD-Umsetzvorrichtung superponiert wird.

Die Signalquelle ist beispielsweise eine vorzugsweise mit Hilfe eines Prozessors steuerbare Signalquelle zur Ausgabe eines definierten analogen Testsignals. Dabei ist unter der Ausgabe des analogen Testsignals eine Beaufschlagung einer Signalleitung mit einem Massepotential, einem konstanten oder variablen Spannungspotential oder einem konstanten oder variablen Strom zu verstehen. Die Schaltvorrichtung ist eingerichtet zur Verteilung des analogen Testsignals auf die Signalleitungen, wobei die Schaltvorrichtung vorzugsweise mit Hilfe eines Prozessors der Steuer- und Auswerteeinheit gesteuert wird.

Weiterhin ist in dem Verfahren vorgesehen, dass während des Testzeitraumes durch die Testeinrichtung das erste Eingangssignal in analoger Form mit dem analogen Testsignal superponiert wird, so dass das analoge Testsignal am ersten Analog-Eingang der AD-Umsetzvorrichtung dominiert und/oder dass das zweite Eingangssignal in analoger Form mit dem analogen Testsignal superponiert wird, so dass das analoge Testsignal am zweiten Analog-Eingang der AD-Umsetzvorrichtung dominiert.

Vorzugsweise ist die Dominanz des analogen Testsignals durch die Auswahl der realen oder komplexen Impedanzen der Dämpfungselemente sowie den Impedanzen der ersten - und zweiten Analog-Ausgänge der Testeinrichtung aufeinander abgestimmt oder durch veränderbare Impedanzen abstimmbar.

Gemäß einer weiteren vorteilhaften Weiterbildung des Verfahrens wird ein Test-Eingang der Testeinrichtung während des Testzeitraums mit dem analogen Testsignal beaufschlagt, wobei das analoge Testsignal von einer steuerbaren Signalquelle, insbesondere Spannungsquelle bereitgestellt wird und wobei die Signalquelle durch eine Steuer- und Auswerteeinrichtung gesteuert wird.

Bei einer als Signalquelle genutzten Spannungsquelle kann es sich um eine Gleich- oder Wechselspannungsquelle zur Ausgabe von konstanten oder variablen Spannungswerten handeln. Dabei sind insbesondere gesteuerte oder geregelte Spannungsquellen vorteilhaft.

Gemäß einer weiteren vorteilhaften Weiterbildung des Verfahrens wird das analoge Testsignal verändert, in dem es automatisch einem vorgegebenen oder vorgebbaren Signalverlauf folgt.

Die Veränderung des analogen Testsignals, beispielsweise die Höhe des Spannungswertes, erfolgt vorzugsweise auf Zeitbasis und kann linear oder in einem anderen funktionalen Zusammenhang mit der Zeit stehen. Daraus können auch zeitliche Abhängigkeiten der AD-Umsetzvorrichtung ermittelt werden. Vorteilhafterweise deckt der Bereich der Spannungswerte mindestens den Arbeitsbereich der AD-Umsetzvorrichtung ab.

Gemäß einer weiteren vorteilhaften Weiterbildung weist das Verfahren eine Steuer- und Auswertevorrichtung auf, die während des Testzeitraumes, das von der Testeinrichtung ausgegebene analoge Testsignal an dem ersten Analog-Eingang der AD-Umsetzvorrichtung und/oder an dem zweiten Analog-Eingang der AD-Umsetzvorrichtung zur Umsetzung des analogen Testsignals in das erste Eingangssignal in digitaler Form gegen einen Erwartungswert prüft und bei Ungleichheit ein Fehlersignal auslöst.

Der Erwartungswert kann auf einem Wert oder einem Wertebereich basieren, dem beispielsweise ein Zahlenwert oder ein Zahlenbereich entspricht. Der Zahlenwert oder Zahlenbereich kann als ein Vergleichswert herangezogen werden und ist abhängig von der AD-Umsetzvorrichtung bzw. von den AD-Umsetzern. Vorzugsweise deckt der Werte- und oder Zahlenbereich mindestens den Messbereich der AD-Umsetzvorrichtung ab oder entspricht diesem.

Die Erfindung ist nicht auf die zuvor erläuterten Weiterbildungen beschränkt, so können Merkmale unterschiedlicher Weiterbildungen kombiniert werden. Weitere Merkmale und Kombinationen von Merkmalen sind in der Figurenbeschreibung enthalten.

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird. Dabei zeigen:
Fig. 1 ein Blockdiagramm einer Sicherheitsschaltung eines Ausführungsbeispiels mit einer Eingangsschaltung, einer Testeinrichtung, einer AD-Umsetzvorrichtung sowie einer Steuer- und Auswerteeinheit,
Fig. 2 ein Blockdiagramm einer Sicherheitsschaltung eines weiteren Ausführungsbeispiels mit beispielsweise drei Sensorsignalen, einer Testeinrichtung, einer AD-Umsetzvorrichtung sowie einer Steuer- und Auswerteeinheit,
Fig. 3 ein Blockdiagramm einer Testeinrichtung eines weiteren Ausführungsbeispiels mit einer Signalquelle,
Fig. 4a, b einen beispielhaften Signalverlauf des Testsignals und des Eingangssignals in analoger Form.

### DETAILLIERTE BESCHREIBUNG

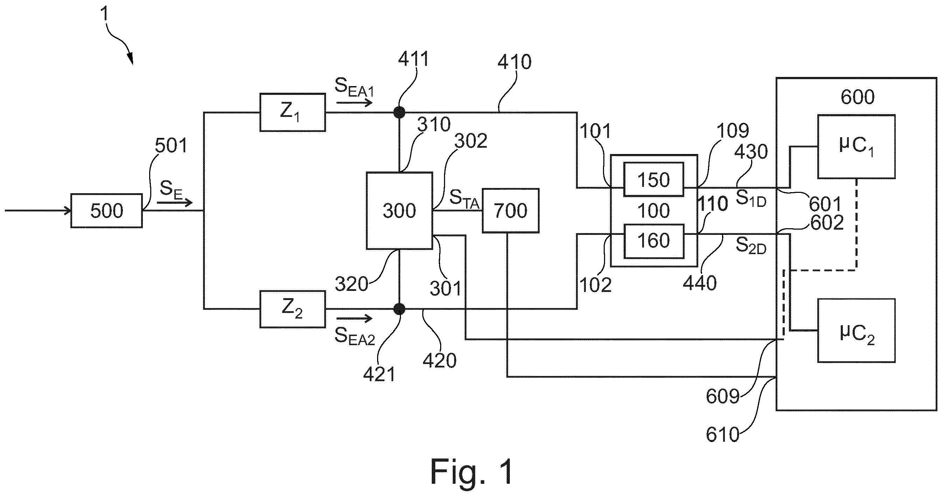

Fig. 1 zeigt ein Blockdiagramm einer Sicherheitsschaltung 1 eines Ausführungsbeispiels. Die Sicherheitsschaltung 1 weist eine Eingangsschaltung 500 zum Anschluss eines analogen Sensors (hier nicht gezeigt) auf. Die Eingangsschaltung besitzt eine Anpassungsschaltung zur Ausgabe eines Sensorsignals S_{E} am Ausgang 501. Eine erste Signalleitung 410 ist an dem Ausgang 501 der Eingangsschaltung 500 und an dem ersten Analog-Eingang 101 der AD-Umsetzvorrichtung 100 angeschlossen. Weiterhin ist eine zweite Signalleitung 420 an dem Ausgang 501 der Eingangsschaltung 500 und an dem zweiten Analog-Eingang 102 der AD-Umsetzvorrichtung 100 angeschlossen.

In der ersten Signalleitung 410 ist das Dämpfungselement Z₁ in Reihe geschaltet, so dass das von der Eingangsschaltung 500 am Ausgang 501 ausgehende Sensorsignal S_{E} gedämpft wird.

Weiterhin ist in der zweiten Signalleitung 420 das Dämpfungselement Z₂ in Reihe geschaltet, so dass das von der Eingangsschaltung 500 am Ausgang 501 ausgehende Sensorsignal S_{E} ebenfalls gedämpft wird.

Die Dämpfungselemente Z₁, Z₂ und die daraus abgeleiteten Dämpfungsfaktoren werden durch deren Impedanzen mitbestimmt. Die mit Hilfe der Dämpfungselemente Z₁ und Z₂ abgedämpften ersten und zweiten Eingangssignale in analoger Form S_{EA1} und S_{EA2} werden in der AD-Umsetzvorrichtung 100 bearbeitet.

Die AD-Umsetzvorrichtung 100, wie im Ausführungsbeispiel der Fig. 1 gezeigt, besteht aus zwei aus dem Stand der Technik bekannten AD-Umsetzer. Die AD-Umsetzer 150 und 160 setzen die an den ersten und zweiten Analog Eingängen 101 und 102 anliegenden ersten und zweiten Eingangssignale in analoger Form S_{EA1} und S_{EA2}, in erste und zweite Eingangssignale in digitale Form S_{1D} und S_{2D} um und geben diese über einen ersten und einen zweiten Digitalausgang 109 und 110 aus.

Zur weiteren Verarbeitung der ersten und zweiten Eingangssignale in digitaler Form S_{1D} und S_{2D}, werden die Signale über Datenleitungen 430 und 440 an einen ersten und einen zweiten Eingang 601 und 602 der Steuer- und Auswertevorrichtung 600 weitergeleitet.

Die Steuer- und Auswertevorrichtung 600 besteht aus zwei Mikrocontrollern µC1 und µ C2, die jeweils datentechnisch miteinander und mit den Eingängen 601 und 602 in Verbindung stehen. Die Mikrocontroller sind dazu eingerichtet, die ersten und zweiten Eingangssignale in digitaler Form S_{1D} und S_{2D} datentechnisch zu verarbeiten, wobei eine Verarbeitung eine Auswertung und/oder eine Weiterleitung, z.B. an eine übergeordnete Steuerung beinhalten kann.

Wie im Ausführungsbeispiel der Fig. 1 dargestellt, weist die Sicherheitsschaltung 1 eine Testeinrichtung 300 auf, wobei der erste Analog-Test-Ausgang 310 der Testeinrichtung 300, der erste Analog-Eingang 101 der AD-Umsetzvorrichtung 100 mit dem Dämpfungselement Z₁ am Knotenpunkt 411 elektrisch miteinander verbunden sind. Weiterhin sind der zweite Analog-Test-Ausgang 320 und der zweite Analog-Eingang 102 der AD-Umsetzvorrichtung 100 mit dem Dämpfungselement Z₂ am Knotenpunkt 421 elektrisch miteinander verbunden.

Die Testeinrichtung 300 weist ferner einen Test-Eingang 302 zur Eingabe eines analogen Testsignals S_{TA} auf. Zur Erzeugung des analogen Testsignals dient eine Signalquelle 700, die mit dem Testeingang 302 verbunden ist. Die Signalquelle ist über eine Steuerleitung mit dem Steuerausgang 610 der Steuer- und Auswerteeinheit 600 verbunden und eingerichtet, das analoge Testsignal S_{TA} gemäß einer Vorgabe durch die Steuer- und Auswertevorrichtung 600 einzustellen.

Zur Steuerung der Testeinrichtung 300 ist der Steuereingang 301 mit der Steuer- und Auswertevorrichtung 600 verbunden. Die Testeinrichtung ist darüber hinaus eingerichtet, das analoge Testsignal S_{TA} auf den ersten Analog-Test-Ausgang 310 und/oder auf den zweiten Analog-Test-Ausgang 320 zu schalten, gemäß einer Vorgabe durch die Steuer- und Auswerteeinheit 600.

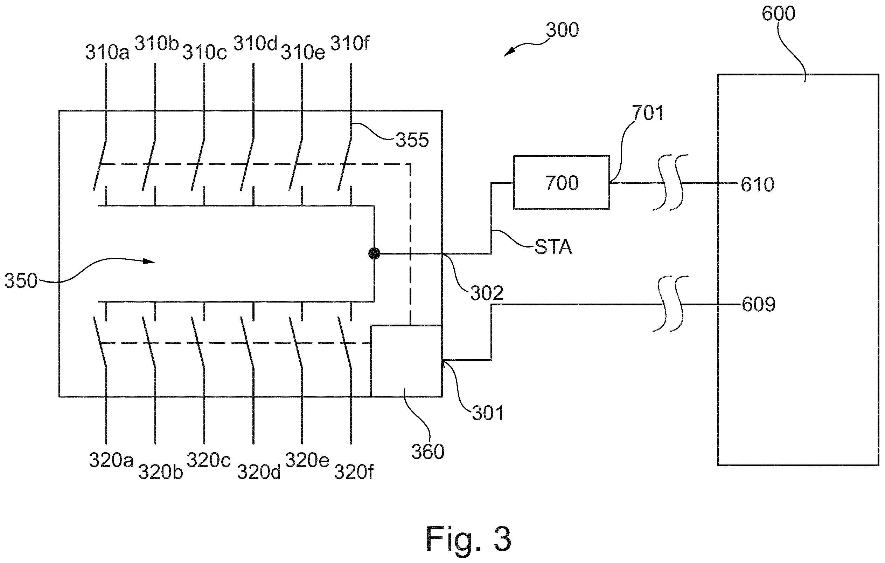

Die Testeinrichtung ist einfach aufgebaut (siehe Ausführungsbeispiel der Fig. 3) und weist eine Schaltlogik 360 und eine Schaltvorrichtung 350 mit einer Anzahl von Schaltern 355 auf, die durch die Schaltlogik angesteuert werden und das analoge Testsignal S_{TA} mit den Analog-Test-Ausgängen, entsprechend den Vorgaben der Steuer- und Auswertelogik verbinden. Dabei bewirkt die geringe Ausgangsimpedanz des ersten Analog-Test-Ausgangs 310 und/oder des zweiten Analog-Test-Ausgangs 320, wie im Ausführungsbeispiel dargestellt, eine deutlich größere Signalamplitude des Testsignals S_{TA} als die Signalamplitude des Eingangssignals (S_{EA1} /S_{EA2}), so dass das analoge Testsignals S_{TA} an dem ersten Analog-Eingang 101 und/oder an dem zweiten Analog-Eingang 102 der AD-Umsetzvorrichtung 100 dominiert.

Mit dem Ausführungsbeispiel aus Fig. 1 ist eine Sicherheitsschaltung realisiert, mit der auf einfache Weise der Signalweg, beispielsweise auf Leitungsbruch getestet werden kann, da sowohl das erste Eingangssignal in analoger Form S_{EA1}, als auch das analoge Testsignal S_{TA} über einen gemeinsamen Signalpfad geführt und ausgewertet werden. Vorteilhafterweise unterliegen den analogen Signalen die gleichen physikalischen Eigenschaften. Weiterhin ist es möglich die AD-Umsetzvorrichtung 100, insbesondere die AD-Umsetzer (150, 160) zu testen.

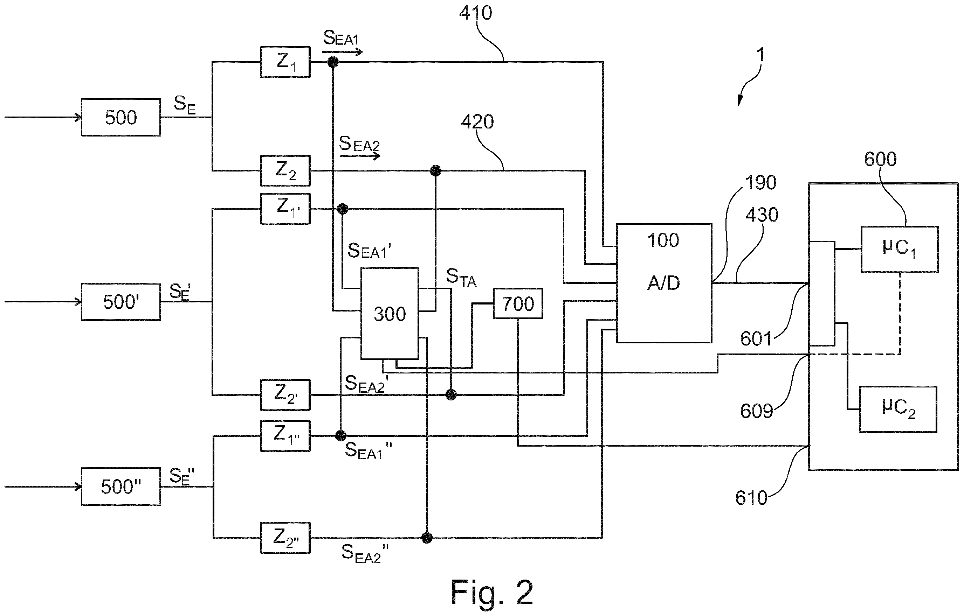

Fig. 2 zeigt ein Blockdiagramm der Sicherheitsschaltung 1 eines weiteren Ausführungsbeispiels mit, aus Gründen der Übersichtlichkeit, beispielsweise 3 Eingangsschaltungen (500, 500', 500") zur unabhängigen Verarbeitung von 3 Sensorsignalen (S_{E}, S_{E}', S_{E}").

Die AD-Umsetzvorrichtung 100 ist eingerichtet zur Verarbeitung einer entsprechenden Anzahl von ersten und zweiten Eingangssignalen in analoger Form (S_{EA1}, S_{EA2}, S_{EA1}', S_{EA2}', S_{EA1}", S_{EA2}").

Die AD-Umsetzvorrichtung 100, ausgeführt beispielsweise als Mikrochip, kann dabei einen integrierten Multiplexer und einen AD-Umsetzer umfassen. Der integrierte Multiplexer kann durch einen der Mikrocontroller µC1 oder µC2 gesteuert werden und leitet das auf den Signalleitungen liegende Eingangssignal in analoger Form S_{EA1,2} und/oder das analoge Testsignal S_{TA} an den AD-Umsetzer zur Umsetzung der analogen Signale (S_{EA1,2} /S_{TA}) in Eingangssignale in digitaler Form weiter. Neben dem Test der korrekten Arbeitsweise des AD-Umsetzers ist es möglich, den integrierten Multiplexer beispielsweise auf Kurzschluss zu prüfen. Dies ist möglich, da sowohl die Eingangssignale analoger Art als auch die analogen Testsignale über denselben Signalpfad geführt werden.

Die Anzahl der zu verarbeitenden Sensorsignale ist abhängig von der Anzahl der ersten und zweiten Analog-Test-Ausgänge der Testeinrichtung 300 (siehe Ausführungsbeispiel Fig. 3) und von der Anzahl der ersten und zweiten Analog-Eingänge der AD-Umsetzvorrichtung 100.

Am Digital-Ausgang 109 der AD-Umsetzvorrichtung 100 stehen die Daten beispielsweise über eine SPI-Schnittstelle (Serial-Peripheral-Interface) der Steuer- und Auswerteeinrichtung zur Verfügung. Dabei ist die Datenleitung (430) geeignet, den Datenstrom an einen Eingang (601) der Steuer- und Auswerteeinrichtung weiterzuleiten. Somit ist mit dem Schaltungsaufbau, wie im Ausführungsbeispiel der Fig.2 beschrieben, eine Testschaltung realisierbar, die auf einfache Weise an eine beliebige Anzahl von Sensoreingängen anpassbar ist.

Fig. 3 zeigt ein Blockdiagramm einer Testeinrichtung 300 eines weiteren Ausführungsbeispiels, ausgelegt für beispielsweise 6 Sensoren. Die Testeinrichtung 300 umfasst eine Schaltvorrichtung 350 mit 12 Schaltern 355, die unabhängig voneinander und individuell durch eine Schaltlogik 360 schaltbar sind und eine leitende Verbindung zwischen dem Test-Eingang 302 und den entsprechenden ersten und/oder zweiten Analog-Test-Ausgängen (310, 320) herstellen können. Die Schaltlogik 360 wird durch eine Steuer- und Auswertevorrichtung über den Steuereingang 301 angesteuert. Die Schalter 355 sind vorzugsweise als integrierte Halbleiterschaltung ausgebildet. Die Testeinrichtung aus Fig. 3 kann beispielsweise durch einen 6 Kanal CMOS Analog-Multiplexer realisiert werden. Weiterhin umfasst die Testeinrichtung 300 über den Test-Eingang 302 zur Eingabe eines analogen Testsignals S_{TA}. Das analoge Testsignal S_{TA} wird von einer Signalquelle 700 erzeugt.

Die Signalquelle 700 ist im Ausführungsbeispiel der Fig. 3 als externes Bauteil ausgebildet und besitzt ebenfalls einen Steuereingang 701. Alternativ kann die Signalquelle 700 in der Testeinrichtung 300 integriert und über eine Schaltlogik 360 ansteuerbar sein. Bei der Signalquelle 700 kann es sich um einen Signalgenerator oder um eine einfache Strom- /Spannungsquelle handeln, die ein konstantes oder variables analoges Signal ausgibt. Ferner ist als Signalquelle 700 auch ein einfacher gegen Massepotential geschalteter Transistor denkbar. Vorzugsweise verfügt die Signalquelle 700 über eine von außen, beispielsweise von einem Prozessor, einer Steuer- und Auswerteschaltung 600 einstellbare Spannungs- oder Stromquelle oder ist als solche ausgebildet. Beispielsweise weist die Signalquelle 700 einen Digital-Analog-Umsetzer zur Erzeugung des Testsignals auf.

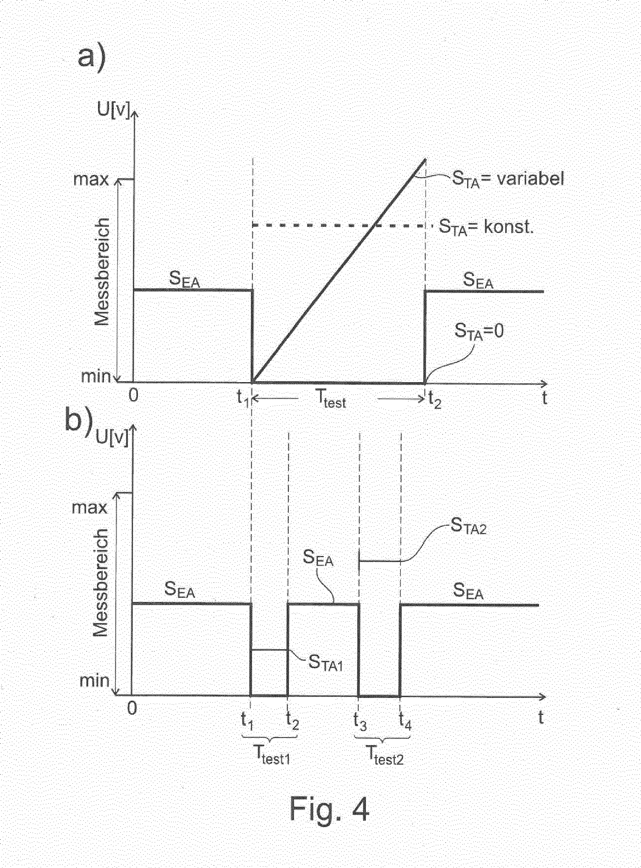

Fig. 4a zeigt beispielsweise einen Spannungsverlauf (U [V]) an einem ersten oder zweiten Eingang 101, 102 einer AD-Umsetzvorrichtung 100 in Abhängigkeit von der Zeit t, wobei S_{EA} einem Eingangssignal in analoger Form und S_{TA} einem analogen Testsignal entsprechen.

Zu einem Zeitpunkt t=o dominiert ein erstes Eingangssignal in analoger Form S_{EA}, beispielsweise an dem ersten Analog-Eingang 101 der AD-Umsetzvorrichtung 100. Zum Zeitpunkt t=t₁ wird das analoge Testsignal S_{TA} durch entsprechende Schalterstellung der Schalter 355 über den ersten AnalogAusgang 310 der Testeinrichtung 300 auf den ersten Analog-Eingang 101 der AD-Umsetzvorrichtung 100 gelegt und überlagert das Eingangssignal in analoger Form S_{EA} bis zu dem Zeitpunkt t=t₂. Dabei kann das analoge Testsignal konstant (S_{TA}= konst.) oder variabel sein. Vorzugsweise durchläuft das analoge Testsignal den gesamten Messbereich der AD-Umsetzvorrichtung, um die korrekte Arbeitsweise festzustellen.

Fig. 4b zeigt ein weiteres Beispiel für einen Spannungsverlauf an einem Eingang einer AD-Umsetzvorrichtung, wobei zwei Tests (Tₜₑₛₜ₁, Tₜₑₛₜ₂) in kurzer Folge durchgeführt werden. Beispielsweise ein erster Test während eines ersten Testzeitraumes Tₜₑₛₜ₁ unterhalb einer Spannung eines Eingangssignals in analoger Form mit einem Testsignal S_{TA}, und ein zweiter Test während eines zweiten Testzeitraumes Tₜₑₛₜ₂ oberhalb der Spannung des Eingangssignals in analoger Form mit einem Testsignal S_{TA2}. Hierbei kann die Dauer eines Tests verkürzt werden, in dem man nicht den gesamten Messbereich durchläuft, sondern nur einzelne Abschnitte des Messbereiches in kurzen Zeitintervallen.

Die Sicherheitsschaltung 1 des Ausführungsbeispiels der Figur 1 weist vorzugsweise mindestens zwei Betriebszustände auf. Ein erster Betriebszustand ist der Normalbetrieb, d.h. es werden die von einem Sensor bereitgestellten analogen Signale in der Eingangsschaltung 500 aufbereitet, am Ausgang 501 der Eingangsschaltung bereitgestellt und mehrkanalig, im vorliegenden Fall zweikanalig, über zwei Signalleitungen 410 und 420 an die AD-Umsetzvorrichtung 100 weitergeleitet. Die AD-Umsetzvorrichtung 100 erzeugt aus den aufbereiteten ersten oder zweiten Eingangssignalen in analoger Form S_{EA1}, S_{AE2} entsprechende erste oder zweite Eingangssignale in digitaler Form S_{1D}, S2D.

Die ersten oder zweiten Daten in digitaler Form S_{1D}, S_{2D} werden über die Datenleitung(en) 430, 440 mit beispielsweise einem seriellen Bus an die Steuer- und Auswertevorrichtung 600 übertragen und mit Hilfe von Programmen auf einem Prozessor oder dem ersten Mikrocontroller µC1 und/oder dem zweiten Mikrocontroller µC2 verarbeitet. Dabei umfasst das Verarbeiten beispielsweise einen Vergleich, der über die Datenleitungen 430 und 440 übermittelten Daten und/oder deren Weiterleitung z.B. an eine übergeordnete Steuerung (SPS).

Ein zweiter Betriebszustand ist der Testbetrieb. In diesem Betriebszustand kann sowohl jeder Signalpfad 410, 420 mit Hilfe der Testeinrichtung 300 auf Leitungsbruch getestet werden als auch die Übertragungskennlinie bzw. Funktion der AD-Umsetzvorrichtung. Darüber hinaus ist es ebenfalls möglich, die von der AD-Umsetzvorrichtung 100 ausgegebenen ersten und/oder zweiten Eingangssignale in digitaler Form S_{1D}, S_{2D} gegen einen Erwartungswert zu prüfen. Vorteilhafterweise wird der Erwartungswert durch die Steuer- und Auswertevorrichtung 600 vorgegeben.

Im Testbetrieb wird eine Testroutine in Form eines Programms, vorzugsweise in der Steuer- und Auswertevorrichtung 600 ausgeführt. Die Testroutine kann von einem Benutzer manuell und/oder zyklisch durch die Steuer- und Auswertevorrichtung 600 oder durch eine überlagerte Steuerung (SPS) initiiert werden und enthält eine Sequenz von Anweisungen zur Ansteuerung von Teilen der Sicherheitsschaltung, insbesondere der Signalquelle 700 der Testeinrichtung 300.

Die Signalquelle 700 wird beispielsweise von einem Prozessor oder vorzugsweise von einem der Mikrocontroller µC1 bzw. µC2 zur Ausgabe eines definierten analogen Testsignals S_{TA} angesteuert. Dieses Testsignal S_{TA} kann ein Massepotential, ein Spannungspotential, ein (zeitlich) variables Spannungspotential oder ein Strom bzw. ein variabler Strom sein (Fig. 4).

Die Testeinrichtung 300 gemäß dem Ausführungsbeispiel der Fig. 3, ansteuerbar durch die Auswerte- und Steuereinrichtung 600, steuert die Schalter 355 mit der Schaltlogik 360 derart, dass die erste Signalleitung 410 über einem der ersten Analogen-Test-Ausgängen, beispielsweise 310a der Testeinrichtung 300, mit dem Analog-Eingang 302 der Testeinrichtung 300 verbunden ist. Das analoge Testsignal S_{TA} überlagert das erste Eingangssignal in analoger Form S_{EA1} auf der Signalleitung 410 und dominiert am Analog-Eingang 101 der AD-Umsetzvorrichtung 100 das erste Eingangssignal in analoger Form S_{EA1}, während das erste Eingangssignal in analoger Form S_{EA1} durch das Dämpfungselement Z1 gedämpft wird.

Im einfachsten Fall wird bei der Dämpfung die Amplitude des ersten Eingangssignals in analoger Form verändert, insbesondere verringert.

Die AD-Umsetzvorrichtung 100 im Ausführungsbeispiel der Fig. 1 wandelt das analoge Testsignal S_{TA} beispielsweise in ein erstes Eingangssignal in digitaler Form S_{1D} um. Die Auswerte- und Steuereinheit 600 prüft das erste Eingangssignal in digitaler Form S_{1D} gegen einen Erwartungswert, der dem digitalisierten analogen Testsignal S_{TA} entspricht. Bei einer Übereinstimmung der Werte kann davon ausgegangen werden, dass die Analog- DigitalWandlung in der AD-Umsetzvorrichtung 100, die zugehörigen Signal- und Datenleitungen sowie die Datenschnittstellen fehlerfrei sind.

Dieser Test kann auch für die zweite Signalleitung 420 durchgeführt werden. Vorteilhafterweise können die Tests in einer zeitlichen Abfolge, beispielsweise nacheinander durchgeführt werden, so dass die vom Sensor ausgegebenen Signale S_{E} weiterhin von der Steuer- und Auswerteeinheit 600 verarbeitet werden können, ohne einen laufenden Prozess zu unterbrechen.

Fig. 4 zeigt ein Diagramm mit einem Signalverlauf in Abhängigkeit von der Zeit, welches beispielsweise am ersten Analog-Eingang (101) der AD-Umsetzvorrichtung (100) anliegt.

Das Eingangssignal in analoger Form S_{AE} wird zum Zeitpunkt t₁, dem Start des Testzeitraumes Tₜₑₛₜ, von dem analogen Testsignal S_{TA} überlagert, wobei das analoge Testsignal S_{TA} in der einfachsten Ausführungsform folgender Bedingung genügt S_{TA} > o und S_{TA} > S_{EA}. Der Testzeitraum wird durch das Zeitintervall Tₜₑₛₜ = t₂ - t₁ definiert. Bei dem analogen Testsignal S_{TA} kann es sich um ein zeitlich konstantes Signal, beispielsweise ein Spannungspotential, einem Massepotential (S_{TA} = o) oder auch um ein konstantes Stromsignal handeln. Es ist aber auch denkbar, dass das analoge Testsignal S_{TA} ein variables Spannungspotential oder ein variabler Strom ist, wobei variabel in diesem Zusammenhang beispielsweise ein über den Testzeitraum Tₜₑₛₜ zeitlich veränderter Verlauf des analogen Testsignals bedeuten kann. Besonders vorteilhaft ist, dass in diesem Test der gesamte Wertebereich der AD-Umsetzvorrichtung durchlaufen wird und somit getestet werden kann.

### BEZUGSZEICHENLISTE

- 1: Sicherheitsschaltung
- 100, 100', 100": AD- Umsetzvorrichtung
- 101, 102: erster, zweiter Analog-Eingang
- 109, 110: erster, zweiter Digital-Ausgang
- 150, 160: AD- Umsetzer
- 300: Testeinrichtung
- 301: Steuereingang
- 302: Test-Eingang
- 310a, ..., 310f: erster Analog-Test-Ausgang
- 320a,..., 320f: zweiter Analog-Test-Ausgang
- 350: Schaltvorrichtung
- 355: Schalter
- 360: Schaltlogik
- 410: erste Signalleitung
- 411: Knotenpunkt
- 420: zweite Signalleitung
- 421: Knotenpunkt
- 430, 440: Datenleitungen
- 500, 500', 500": Eingangsschaltung
- 501: Ausgang
- 600: Steuer- und Auswertevorrichtung
- 601: erster Eingang
- 602: zweiter Eingang
- 609: Steuerausgang
- 610: Steuerausgang für Signalquelle
- 700: Signalquelle
- 701: Steuereingang
- S_{E}, S_{E}' S_{E}": Sensorsignal
- S_{EA1}, S_{EA1}', S_{EA2}": erstes Eingangssignal in analoger Form
- S_{EA2}, S_{EA2}', S_{EA2}": zweites Eingangssignal in analoger Form
- S_{1D}, S_{1D}', S_{1D}": erstes Eingangssignal in digitaler Form
- S_{2D}, S_{2D}', S_{2D}": zweites Eingangssignal in digitaler Form
- S_{TA}: analoges Testsignal
- Z₁, Z₁', Z₁": Dämpfungselement
- Z₂, Z₂', Z₂": Dämpfungselement
- µC₁: erster Controller
- µC₂: zweiter Controller
- Tₜₑₛₜ: Testzeitraum
- t₁, t₂: Startzeit, Endzeit
- t₃, t₄: Startzeit, Endzeit

## Patentansprüche

1. Sicherheitsschaltung (1) zum mehrkanaligen Verarbeiten eines Eingangssignals (S_{E}), insbesondere eines Sensorsignals mit:
- einer Eingangsschaltung (500) eingerichtet zur Eingabe des Eingangssignals (S_{E}) und Bereitstellung des Eingangssignals (S_{E}) an seinem Ausgang (501)
- einer AD-Umsetzvorrichtung (100) mit einem ersten Analog-Eingang (101) und einem zweiten Analog- Eingang (102) und mindestens einem Digital-Ausgang (109, 110),
- einer ersten Signalleitung (410) angeschlossen an dem Ausgang (501) der Eingangsschaltung (500) und an dem ersten Analog-Eingang (101) der AD-Umsetzvorrichtung (100) zur Weiterleitung eines ersten Eingangssignals in analoger Form (S_{EA1}), wobei die AD-Umsetzvorrichtung (100) eingerichtet ist, das erste Eingangssignal in analoger Form (S_{EA1}) am ersten Analog-Eingang (101) in ein erstes Eingangssignal in digitaler Form (S_{1D}) umzusetzen und an dem Digital-Ausgang (109, 110) auszugeben,
- einer zweiten Signalleitung (420) angeschlossen an dem Ausgang (501) der Eingangsschaltung (500) und an dem zweiten Analog-Eingang (102) der AD-Umsetzvorrichtung (100) zur Weiterleitung eines zweiten Eingangssignals in analoger Form (S_{EA2}), wobei die AD-Umsetzvorrichtung (100) eingerichtet ist, das zweite Eingangssignal in analoger Form (S_{EA2}) am zweiten Analog-Eingang (102) in ein zweites Eingangssignal in digitaler Form (S_{2D}) umzusetzen und an dem Digital-Ausgang (109, 110) auszugeben,
- einer Steuer- und Auswertevorrichtung (600) zur Auswertung des ersten Eingangssignals in digitaler Form (S_{1D}) und des zweiten Eingangssignals in digitaler Form (S_{2D}), wobei der mindestens eine Digital-Ausgang (109, 110) der AD-Umsetzvorrichtung (100) mit mindestens einem Eingang (601, 602) der Steuer- und Auswertevorrichtung (600) verbunden ist,
- einer Testeinrichtung (300) zur Ausgabe eines analogen Testsignals (S_{TA}), wobei die Testeinrichtung (300) einen Steuereingang (301) aufweist, der mit einem Steuerausgang (609) der Steuer- und Auswertevorrichtung (600) verbunden ist und wobei die Steuer- und Auswertevorrichtung (600) weiterhin eingerichtet ist, die Testeinrichtung (300) zu steuern,
**dadurch gekennzeichnet, dass**
die Testeinrichtung (300) einen ersten Analog-Test-Ausgang (310) zur Ausgabe des analogen Testsignals (S_{TA}) aufweist, der in einem ersten Knotenpunkt (411) an die erste Signalleitung (410) angeschlossen ist und dass
die Testeinrichtung (300) einen zweiten Analog-Test-Ausgang (320) zur Ausgabe des analogen Testsignals (S_{TA}) aufweist, der in einem zweiten Knotenpunkt (421) an die zweite Signalleitung (420) angeschlossen ist, und dass
die erste Signalleitung (410) ein erstes Dämpfungselement (Z₁) aufweist, so dass die Eingangsschaltung (500) unter Zwischenschaltung des ersten Dämpfungselementes (Z₁) an dem ersten Analog-Eingang (101) der AD-Umsetzvorrichtung (100) angeschlossen ist, und dass
die zweite Signalleitung (420) ein zweites Dämpfungselement (Z₂) aufweist, so dass die Eingangsschaltung (500) unter Zwischenschaltung des zweiten Dämpfungselementes (Z₂) an dem zweiten Analog-Eingang (102) der AD-Umsetzvorrichtung (100) angeschlossen ist, und dass
das erste Dämpfungselement (Z₁), das zweite Dämpfungselement (Z₂), und eine Ausgangsimpedanz der Testeinrichtung (300) derart dimensioniert sind,
dass das erste Eingangssignal in analoger Form (S_{EA1}) und das analoge Testsignal (S_{TA}) während des Testzeitraumes an dem ersten Analog-Eingang (101) der AD-Umsetzvorrichtung (100) sich überlagern, und / oder
dass das zweite Eingangssignal in analoger Form (S_{EA2}) und das analoge Testsignal (S_{TA}) während des Testzeitraumes an dem zweiten Analog-Eingang (102) der AD-Umsetzvorrichtung (100) sich überlagern,
so dass das analoge Testsignal (S_{TA}) das erste Eingangssignal in analoger Form (S_{EA1}) beziehungsweise das zweite Eingangssignal in analoger Form (S_{EA2}) dominiert.

2. Sicherheitsschaltung nach Anspruch 1,
**dadurch gekennzeichnet, dass**
die Testeinrichtung (300) einen Test-Eingang (302) zur Eingabe des analogen Testsignals (S_{TA}) aufweist, wobei zumindest während eines Testzeitraumes (Tₜₑₛₜ) das analoge Testsignal (S_{TA}) anliegt,
wobei insbesondere eine Signalquelle (700) mit dem Test-Eingang (302) verbunden ist und wobei die Signalquelle (700) ausgebildet ist, das analoge Testsignal (S_{TA}), insbesondere mittels einer Spannungs- oder Stromquelle zu erzeugen.

3. Sicherheitsschaltung nach einem der vorhergehenden Ansprüche,
**dadurch gekennzeichnet, dass**
das analoge Testsignal (S_{TA}) ein Massepotential oder ein konstantes Spannungspotential oder ein variables Spannungspotential ist.

4. Sicherheitsschaltung nach einem der vorhergehenden Ansprüche,
**dadurch gekennzeichnet, dass**
das analoge Testsignal (S_{TA}) ein konstanter oder ein variabler Strom ist.

5. Sicherheitsschaltung nach einem der vorhergehenden Ansprüche,
**dadurch gekennzeichnet, dass**
das analoge Testsignal (S_{TA}) während des Testzeitraumes (Tₜₑₛₜ) einem vorgegebenen oder vorgebbaren Signalverlauf folgt.

6. Sicherheitsschaltung nach einem der vorhergehenden Ansprüche,
**dadurch gekennzeichnet, dass**
die Testeinrichtung (300) eine Schaltvorrichtung (350) aufweist, wobei die Schaltvorrichtung (350) eingerichtet ist, das analoge Testsignal (S_{TA}) auf den ersten Analog-Test-Ausgang (310) und/oder auf den zweiten Analog-Test-Ausgang (320) zu schalten.

7. Sicherheitsschaltung nach Anspruch 6,
**dadurch gekennzeichnet, dass**
die Schaltvorrichtung (350) mindestens zwei Schalter (355) aufweist,
wobei die Schalter (355) einzeln und / oder in Gruppen ansteuerbar sind.

8. Sicherheitsschaltung nach einem der vorhergehenden Ansprüche,
**dadurch gekennzeichnet, dass**
die Steuer- und Auswertevorrichtung (600) einen Prozessor zur Verarbeitung des ersten Eingangssignals in digitaler Form (S_{1D}) und/ oder des zweiten Eingangssignals in digitaler Form (S_{2D}) aufweist.

9. Sicherheitsschaltung nach einem der vorhergehenden Ansprüche,
**dadurch gekennzeichnet, dass**
die AD-Umsetzvorrichtung (100)
einen ersten AD-Umsetzer (150) und einen zweiten AD-Umsetzer (160) aufweist,
wobei der erste AD-Umsetzer (150) eingerichtet ist, das erste Eingangssignal in analoger Form (S_{EA1}) in das erste Eingangssignal in digitaler Form (S_{1D}) umzusetzen und an dem Digital-Ausgang (109) auszugeben und
wobei der zweite AD-Umsetzer (160) eingerichtet ist, das zweite Eingangssignal in analoger Form (S_{EA2}) in das zweite Eingangssignal in digitaler Form (S_{2D}) umzusetzen und an dem Digital-Ausgang (110) auszugeben.

10. Verfahren zum Testen einer Sicherheitsschaltung mit
einer Signalquelle (700) zum Erzeugen eines analogen Testsignals (S_{TA}) und einer Testeinrichtung (300) zur Ausgabe des analogen Testsignals (S_{TA}),
wobei das analoge Testsignal (S_{TA}) auf einer ersten Signalleitung (410) in einem ersten Knotenpunkt (411) und/oder auf einer zweiten Signalleitung (420) in einem zweiten Knotenpunkt (421) ausgegeben wird derart,
dass während eines Testzeitraumes (Tₜₑₛₜ) das an einem Test-Eingang (302) der Testeinrichtung (300) anliegende analoge Testsignal (S_{TA}) über eine Schaltvorrichtung (350) derart verbunden wird,
dass ein erster Analog-Eingang (101) einer AD-Umsetzvorrichtung (100) und/oder ein zweiter Analog-Eingang (102) der AD-Umsetzvorrichtung (100) mit dem analogen Testsignal (S_{TA}) beaufschlagt wird,
so dass das analoge Testsignal (S_{TA}) mit einem ersten Eingangssignal in analoger Form (S_{EA1}) an dem ersten Analog-Eingang (101) der AD-Umsetzvorrichtung (100) und/oder dass
das analoge Testsignal (S_{TA}) mit einem zweiten Eingangssignal in analoger Form (S_{EA2}) an dem zweiten Analog-Eingang (102) der AD-Umsetzvorrichtung (100) superponiert wird,
wobei die erste Signalleitung (410) ein erstes Dämpfungselement (Z₁) aufweist, so dass die Eingangsschaltung (500) unter Zwischenschaltung des ersten Dämpfungselementes (Z₁) an dem ersten Analog-Eingang (101) der AD-Umsetzvorrichtung (100) angeschlossen ist, und
wobei die zweite Signalleitung (420) ein zweites Dämpfungselement (Z₂) aufweist, so dass die Eingangsschaltung (500) unter Zwischenschaltung des zweiten Dämpfungselementes (Z₂) an dem zweiten Analog-Eingang (102) der AD- Umsetzvorrichtung (100) angeschlossen ist, und
wobei das erste Dämpfungselement (Z₁), das zweite Dämpfungselement (Z₂), und eine Ausgangsimpedanz der Testeinrichtung (300) derart dimensioniert sind, dass
das erste Eingangssignal in analoger Form (S_{EA1}) und das analoge Testsignal (S_{TA}) während des Testzeitraumes an dem ersten Analog-Eingang (101) der AD-Umsetzvorrichtung (100) sich überlagern, und / oder
das zweite Eingangssignal in analoger Form (S_{EA2}) und das analoge Testsignal (S_{TA}) während des Testzeitraumes an dem zweiten Analog-Eingang (102) der AD-Umsetzvorrichtung (100) sich überlagern,
so dass das analoge Testsignal (S_{TA}) das erste Eingangssignal in analoger Form (S_{EA1}) beziehungsweise das zweite Eingangssignal in analoger Form (S_{EA2}) dominiert.

11. Verfahren nach Anspruch 10,
**dadurch gekennzeichnet, dass**
ein Test-Eingang (302) der Testeinrichtung (300) während des Testzeitraums (Tₜₑₛₜ) mit dem analogen Testsignal (S_{TA}) beaufschlagt wird, und dass das analoge Testsignal (S_{TA}) von einer steuerbaren Signalquelle (700), insbesondere Spannungsquelle bereitgestellt wird, wobei die Signalquelle (700) durch eine Steuer- und Auswerteeinrichtung (600) gesteuert wird.

12. Verfahren einem der vorhergehenden Ansprüche,
**dadurch gekennzeichnet, dass**
das analoge Testsignal (S_{TA}) verändert wird, in dem es automatisch einem vorgegebenen oder vorgebbaren Signalverlauf folgt.

13. Verfahren nach einem der vorhergehenden Ansprüche,
**dadurch gekennzeichnet, dass**
während des Testzeitraumes Tₜₑₛₜ) das von der Testeinrichtung (300) ausgegebene analoge Testsignal (S_{TA}), an dem ersten Analog-Eingang (101) der AD-Umsetzvorrichtung (100) und/oder an dem zweiten Analog-Eingang (102) der AD-Umsetzvorrichtung (100) zur Umsetzung des analogen Testsignals (S_{TA}) in das erste Eingangssignal in digitaler Form (S_{1D}, S_{2D}) anliegt, und
eine Steuer- und Auswerteeinrichtung (600) das erste Eingangssignal in digitaler Form (S_{1D}, S_{2D}) gegen einen Erwartungswert prüft und bei Ungleichheit ein Fehlersignal auslöst.

## Claims

1. Safety circuit (1) for the multichannel processing of an input signal (S_{E}), in particular of a sensor signal, having:
- an input circuit (500) configured for inputting the input signal (S_{E}) and providing the input signal (S_{E}) at its output (501),
- an AD conversion apparatus (100) having a first analogue input (101) and a second analogue input (102) and at least one digital output (109, 110),
- a first signal line (410) connected to the output (501) of the input circuit (500) and to the first analogue input (101) of the AD conversion apparatus (100) for forwarding a first input signal in analogue form (S_{EA1}), wherein the AD conversion apparatus (100) is configured to convert the first input signal in analogue form (S_{EA1}) at the first analogue input (101) into a first input signal in digital form (S_{1D}) and output it at the digital output (109, 110),
- a second signal line (420) connected to the output (501) of the input circuit (500) and to the second analogue input (102) of the AD conversion apparatus (100) for forwarding a second input signal in analogue form (S_{EA2}), wherein the AD conversion apparatus (100) is configured to convert the second input signal in analogue form (S_{EA2}) at the second analogue input (102) into a second input signal in digital form (S_{2D}) and output it at the digital output (109, 110),
- a control and evaluation apparatus (600) for evaluating the first input signal in digital form (S_{1D}) and the second input signal in digital form (S_{2D}), wherein the at least one digital output (109, 110) of the AD conversion apparatus (100) is connected to at least one input (601, 602) of the control and evaluation apparatus (600),
- a test device (300) for outputting an analogue test signal (S_{TA}), wherein the test device (300) has a control input (301) which is connected to a control output (609) of the control and evaluation apparatus (600) and wherein the control and evaluation apparatus (600) is further configured to control the test device (300),
**characterized in that**
the test device (300) has a first analogue test output (310) for outputting the analogue test signal (S_{TA}), which first analogue test output is connected to the first signal line (410) at a first node (411), and **in that**
the test device (300) has a second analogue test output (320) for outputting the analogue test signal (S_{TA}), which second analogue test output is connected to the second signal line (420) at a second node (421), and **in that**
the first signal line (410) has a first damping element (Z₁) such that the input circuit (500) is connected to the first analogue input (101) of the AD conversion apparatus (100) with the interposition of the first damping element (Z₁), and **in that**
the second signal line (420) has a second damping element (Z₂) such that the input circuit (500) is connected to the second analogue input (102) of the AD conversion apparatus (100) with the interposition of the second damping element (Z₂), and **in that**
the first damping element (Z₁), the second damping element (Z₂), and an output impedance of the test device (300) are dimensioned in such a way
that the first input signal in analogue form (S_{EA1}) and the analogue test signal (S_{TA}) overlap at the first analogue input (101) of the AD conversion apparatus (100) during the test period, and/or
that the second input signal in analogue form (S_{EA2}) and the analogue test signal (S_{TA}) overlap at the second analogue input (102) of the AD conversion apparatus (100) during the test period,
such that the analogue test signal (S_{TA}) dominates the first input signal in analogue form (S_{EA1}) and second input signal in analogue form (S_{EA2}), respectively.

2. Safety circuit according to Claim 1,
**characterized in that**
the test device (300) has a test input (302) for inputting the analogue test signal (S_{TA}) , wherein the analogue test signal (S_{TA}) is applied at least during a test period (Tₜₑₛₜ) ,
wherein in particular a signal source (700) is connected to the test input (302) and wherein the signal source (700) is designed to generate the analogue test signal (S_{TA}) , in particular by means of a voltage source or current source.

3. Safety circuit according to one of the preceding claims,
**characterized in that**
the analogue test signal (S_{TA}) is a ground potential or a constant voltage potential or a variable voltage potential.

4. Safety circuit according to one of the preceding claims,
**characterized in that**
the analogue test signal (S_{TA}) is a constant current or a variable current.

5. Safety circuit according to one of the preceding claims,
**characterized in that**
the analogue test signal (S_{TA}) follows a predefined or predefinable signal characteristic during the test period (Tₜₑₛₜ) .

6. Safety circuit according to one of the preceding claims,
**characterized in that**
the test device (300) has a switching apparatus (350), wherein the switching apparatus (350) is configured to switch the analogue test signal (S_{TA}) to the first analogue test output (310) and/or to the second analogue test output (320).

7. Safety circuit according to Claim 6,
**characterized in that**
the switching apparatus (350) has at least two switches (355) ,
wherein the switches (355) are able to be actuated individually and/or in groups.

8. Safety circuit according to one of the preceding claims,
**characterized in that**
the control and evaluation apparatus (600) has a processor for processing the first input signal in digital form (S_{1D}) and/or the second input signal in digital form (S_{2D}) .

9. Safety circuit according to one of the preceding claims,
**characterized in that**
the AD conversion apparatus (100)
has a first AD converter (150) and a second AD converter (160) ,
wherein the first AD converter (150) is configured to convert the first input signal in analogue form (S_{EA1}) into the first input signal in digital form (S_{1D}) and to output it at the digital output (109) and
wherein the second AD converter (160) is configured to convert the second input signal in analogue form (S_{EA2}) into the second input signal in digital form (S_{2D}) and to output it at the digital output (110).

10. Method for testing a safety circuit having
a signal source (700) for generating an analogue test signal (S_{TA}) and a test device (300) for outputting the analogue test signal (S_{TA}),
wherein the analogue test signal (S_{TA}) is output to a first signal line (410) at a first node (411) and/or to a second signal line (420) at a second node (421) in such a way
that during a test period (Tₜₑₛₜ) the analogue test signal (S_{TA}) applied to a test input (302) of the test device (300) is connected via a switching apparatus (350) in such a way
that a first analogue input (101) of an AD conversion apparatus (100) and/or a second analogue input (102) of the AD conversion apparatus (100) are/is supplied with the analogue test signal (S_{TA}),
such that the analogue test signal (S_{TA}) is superimposed with a first input signal in analogue form (S_{EA1}) at the first analogue input (101) of the AD conversion apparatus (100) and/or that
the analogue test signal (S_{TA}) is superimposed with a second input signal in analogue form (S_{EA2}) at the second analogue input (102) of the AD conversion apparatus (100),
wherein the first signal line (410) has a first damping element (Z₁) such that the input circuit (500) is connected to the first analogue input (101) of the AD conversion apparatus (100) with the interposition of the first damping element (Z₁), and
wherein the second signal line (420) has a second damping element (Z₂) such that the input circuit (500) is connected to the second analogue input (102) of the AD conversion apparatus (100) with the interposition of the second damping element (Z₂), and
wherein the first damping element (Z₁), the second damping element (Z₂), and an output impedance of the test device (300) are dimensioned in such a way that
the first input signal in analogue form (S_{EA1}) and the analogue test signal (S_{TA}) overlap at the first analogue input (101) of the AD conversion apparatus (100) during the test period, and/or
the second input signal in analogue form (S_{EA2}) and the analogue test signal (S_{TA}) overlap at the second analogue input (102) of the AD conversion apparatus (100) during the test period,
such that the analogue test signal (S_{TA}) dominates the first input signal in analogue form (S_{EA1}) and second input signal in analogue form (S_{EA2}), respectively.

11. Method according to Claim 10,
**characterized in that**
a test input (302) of the test device (300) is supplied with the analogue test signal (S_{TA}) during the test period (Tₜₑₛₜ), and **in that** the analogue test signal (S_{TA}) is provided from a controllable signal source (700), in particular voltage source, wherein the signal source (700) is controlled by a control and evaluation device (600) .

12. Method according to one of the preceding claims,
**characterized in that**
the analogue test signal (S_{TA}) is changed, whereby it automatically follows a predefined or predefinable signal characteristic.

13. Method according to one of the preceding claims,
**characterized in that**
during the test period (Tₜₑₛₜ) the analogue test signal (S_{TA}) output from the test device (300) is applied to the first analogue input (101) of the AD conversion apparatus (100) and/or to the second analogue input (102) of the AD conversion apparatus (100) in order to convert the analogue test signal (S_{TA}) into the first input signal in digital form (S_{1D}, S_{2D}), and a control and evaluation device (600) checks the first input signal in digital form (S_{1D}, S_{2D}) against an expected value and triggers an error signal if they are not equal.

## Revendications

1. Circuit de sécurité (1) destiné à effectuer un traitement multicanal d'un signal d'entrée (S_{E}), notamment d'un signal de capteur, ldit circuit de sécurité comprenant :
- un circuit d'entrée (500) conçu pour entrer le signal d'entrée (S_{E}) et fournir le signal d'entrée (S_{E}) à sa sortie (501),
- un dispositif de conversion AD (100) pourvu d'une première entrée analogique (101) et d'une deuxième entrée analogique (102) et d'au moins une sortie numérique (109, 110),
- une première ligne de signal (410) connectée à la sortie (501) du circuit d'entrée (500) et à la première entrée analogique (101) du dispositif de conversion AD (100) afin de transmettre un premier signal d'entrée sous forme analogique (S_{EA1}), le dispositif de conversion AD (100) étant conçu pour convertir le premier signal d'entrée sous forme analogique (S_{EA1}) à la première entrée analogique (101) en un premier signal d'entrée sous forme numérique (S_{1D}) et le délivrer à la sortie numérique (109, 110),
- une deuxième ligne de signal (420) connectée à la sortie (501) du circuit d'entrée (500) et à la deuxième entrée analogique (102) du dispositif de conversion AD (100) afin de transmettre un deuxième signal d'entrée sous forme analogique (S_{EA2}), le dispositif de conversion AD (100) étant conçu pour convertir le deuxième signal d'entrée sous forme analogique (S_{EA2}) à la deuxième entrée analogique (102) en un deuxième signal d'entrée sous forme numérique (S_{2D}) et le délivrer à la sortie numérique (109, 110),
- un dispositif de commande et d'évaluation (600) destiné à évaluer le premier signal d'entrée sous forme numérique (S_{1D}) et le deuxième signal d'entrée sous forme numérique (S_{2D}), l'au moins une sortie numérique (109, 110) du dispositif de conversion AD (100) étant reliée à au moins une entrée (601, 602) du dispositif de commande et d'évaluation (600),
- un module de test (300) destiné à délivrer un signal de test analogique (S_{TA}), le dispositif de test (300) comportant une entrée de commande (301) qui est reliée à une sortie de commande (609) du dispositif de commande et d'évaluation (600) et le dispositif de commande et d'évaluation (600) étant en outre conçu pour commander le module de test (300),
**caractérisé en ce que**
le module de test (300) comporte une première sortie de test analogique (310) destiné à délivrer le signal de test analogique (S_{TA}), laquelle est connectée à la première ligne de signal (410) dans un premier noeud (411) et
le module de test (300) comporte une deuxième sortie de test analogique (320) destinée à délivrer le signal de test analogique (S_{TA}), laquelle est connectée à la deuxième ligne de signal (420) dans un deuxième noeud (421), et
la première ligne de signal (410) comporte un premier élément d'atténuation (Z₁), de sorte que le circuit d'entrée (500) est connecté à la première entrée analogique (101) du dispositif de conversion AD (100) avec interposition du premier élément d'atténuation (Z₁), et
la deuxième ligne de signal (420) comporte un deuxième élément d'atténuation (Z₂), de sorte que le circuit d'entrée (500) est connecté à la deuxième entrée analogique (102) du dispositif de conversion AD (100) avec interposition du deuxième élément d'atténuation (Z₂), et
le premier élément d'atténuation (Z₁), le deuxième élément d'atténuation (Z₂) et une impédance de sortie du module de test (300) sont dimensionnés de manière à ce que
le premier signal d'entrée sous forme analogique (S_{EA1}) et le signal de test analogique (S_{TA}) se superposent à la première entrée analogique (101) du dispositif de conversion AD (100) pendant la période de test, et/ou le deuxième signal d'entrée sous forme analogique (S_{EA2}) et le signal de test analogique (S_{TA}) se superposent à la deuxième entrée analogique (102) du dispositif de conversion AD (100) pendant la période de test,
de sorte que le signal de test analogique (S_{TA}) domine soit le premier signal d'entrée sous forme analogique (S_{EA1}) soit le deuxième signal d'entrée sous forme analogique (S_{EA2}).

2. Circuit de sécurité selon la revendication 1,
**caractérisé en ce que**
le module de test (300) comporte une entrée de test (302) destinéeà entrer le signal de test analogique (S_{TA}), le signal de test analogique (S_{TA}) étant présent au moins pendant une période de test (Tₜₑₛₜ),
en particulier une source de signal (700) étant connectée à l'entrée de test (302) et la source de signal (700) étant conçue pour générer le signal de test analogique (S_{TA}), notamment au moyen d'une source de tension ou de courant.

3. Circuit de sécurité selon l'une des revendications précédentes,
**caractérisé en ce que**
le signal de test analogique (S_{TA}) est un potentiel de masse ou un potentiel de tension constante ou un potentiel de tension variable.

4. Circuit de sécurité selon l'une des revendications précédentes,
**caractérisé en ce que**
le signal de test analogique (S_{TA}) est un courant constant ou un courant variable.

5. Circuit de sécurité selon l'une des revendications précédentes,
**caractérisé en ce que**
le signal de test analogique (S_{TA}) suit pendant la période de test (Tₜₑₛₜ) une courbe de signal spécifiée ou spécifiable.

6. Circuit de sécurité selon l'une des revendications précédentes,
**caractérisé en ce que**
le module de test (300) comporte un dispositif de commutation (350), le dispositif de commutation (350) étant conçu pour commuter le signal de test analogique (S_{TA}) sur la première sortie de test analogique (310) et/ou sur la deuxième sortie de test analogique (320).

7. Circuit de sécurité selon la revendication 6,
**caractérisé en ce que**
le dispositif de commutation (350) comporte au moins deux commutateurs (355),
les commutateurs (355) pouvant être commandés individuellement et/ou en groupes.

8. Circuit de sécurité selon l'une des revendications précédentes,
**caractérisé en ce que**
le dispositif de commande et d'évaluation (600) comporte un processeur destiné à traiter le premier signal d'entrée sous forme numérique (S_{1D}) et/ou le deuxième signal d'entrée sous forme numérique (S_{2D}).

9. Circuit de sécurité selon l'une des revendications précédentes,
**caractérisé en ce que**
le dispositif de conversion AD (100) comporte un premier convertisseur AD (150) et un deuxième convertisseur AD (160),
le premier convertisseur AD (150) étant conçu pour convertir le premier signal d'entrée sous forme analogique (S_{EA1}) en le premier signal d'entrée sous forme numérique (S_{1D}) et le délivrer à la sortie numérique (109) et
le deuxième convertisseur AD (160) étant conçu pour convertir le deuxième signal d'entrée sous forme analogique (S_{EA2}) en le deuxième signal d'entrée sous forme numérique (S_{2D}) et le délivrer à la sortie numérique (110) .

10. Procédé de test d'un circuit de sécurité comprenant une source de signal (700) destinée à générer un signal de test analogique (S_{TA}) et un module de test (300) destiné à délivrer le signal de test analogique (S_{TA}), le signal de test analogique (S_{TA}) étant délivré sur une première ligne de signal (410) dans un premier noeud (411) et/ou sur une deuxième ligne de signal (420) dans un deuxième noeud (421) de manière à ce que
pendant une période de test (Tₜₑₛₜ), le signal de test analogique (S_{TA}) présent à une entrée de test (302) du module de test (300) soit relié par le biais d'un dispositif de commutation (350) de manière à ce que une première entrée analogique (101) d'un dispositif de conversion AD (100) et/ou une deuxième entrée analogique (102) d'un dispositif de conversion AD (100) soient alimentées avec le signal de test analogique (S_{TA}),
de sorte que le signal de test analogique (S_{TA}) soit superposé à un premier signal d'entrée sous forme analogique (S_{EA1}) à la première entrée analogique (101) du dispositif de conversion AD (100) et/ou
de sorte que le signal de test analogique (S_{TA}) soit superposé à un deuxième signal d'entrée sous forme analogique (S_{EA2}) à la deuxième entrée analogique (102) du dispositif de conversion AD (100),
la première ligne de signal (410) comportant un premier élément d'atténuation (Z₁), de sorte que le circuit d'entrée (500) soit connecté à la première entrée analogique (101) du dispositif de conversion AD (100) avec interposition du premier élément d'atténuation (Z₁), et
la deuxième ligne de signal (420) comportant un deuxième élément d'atténuation (Z₂), de sorte que le circuit d'entrée (500) soit connecté à la deuxième entrée analogique (102) du dispositif de conversion AD (100) avec interposition du deuxième élément d'atténuation (Z₂), et
le premier élément d'atténuation (Z₁), le deuxième élément d'atténuation (Z₂), et une impédance de sortie du module de test (300) étant dimensionnées de manière à ce que
le premier signal d'entrée sous forme analogique (S_{EA1}) et le signal de test analogique (S_{TA}) se superposent pendant la période de test à la première entrée analogique (101) du dispositif de conversion AD (100), et/ou
le deuxième signal d'entrée sous forme analogique (S_{EA2}) et le signal analogique de test (S_{TA}) se superposent à la deuxième entrée analogique (102) du dispositif de conversion AD (100) pendant la période de test,
de sorte que le signal de test analogique (S_{TA}) domine le premier signal d'entrée sous forme analogique (S_{EA1}) ou le deuxième signal d'entrée sous forme analogique (S_{EA2}).

11. Procédé selon la revendication 10,
**caractérisé en ce que**
une entrée de test (302) du module de test (300) est alimentée avec le signal de test analogique (S_{TA}) pendant la période de test (Tₜₑₛₜ), et
le signal de test analogique (S_{TA}) est fourni par une source de signal commandable (700), en particulier une source de tension, la source de signal (700) étant commandée par un module de commande et d'évaluation (600) .

12. Procédé selon l'une des revendications précédentes,
**caractérisé en ce que**
le signal de test analogique (S_{TA}) est modifié en suivant automatiquement une courbe de signal spécifiée ou spécifiable.

13. Procédé selon l'une des revendications précédentes,
**caractérisé en ce que**
pendant la période de test (Tₜₑₛₜ) le signal de test analogique (S_{TA}), délivré par le module de test (300), est présent à la première entrée analogique (101) du dispositif de conversion AD (100) et/ou à la deuxième entrée analogique (102) du dispositif de conversion AD (100) afin de convertir le signal de test analogique (S_{TA}) en le premier signal d'entrée sous forme numérique (S_{1D}, S_{2D}), et
un module de commande et d'évaluation (600) vérifie le premier signal d'entrée sous forme numérique (S_{1D}, S_{2D}) par rapport à une valeur attendue et déclenche un signal d'erreur en cas d'inégalité.
